# EUROPEAN PATENT SPECIFICATION

(11) **EP 2 249 699 B1**
(45) Date of publication and mention of the grant of the patent: **20.11.2013**
(21) Application number: 08780636.0
(22) Date of filing: 09.05.2008
(51) Int. Cl.: A61B 5/055, G01R 33/34, G01V 3/00, G01R 33/36

(54) **DIFFERENTIAL TUNING OF QUADRATURE MODES OF A MAGNETIC RESONANCE COIL**
DIFFERENTIAL-TUNING VON QUADRATURMODI EINER MAGNETRESONANZSPULE
RÉGLAGE DIFFÉRENTIEL DE MODES DE QUADRATURE D'UNE BOBINE À RÉSONANCE MAGNÉTIQUE

(30) Priority: 25.01.2008 US 66140 P
(43) Date of publication of application: 17.11.2010
(73) Proprietor: Agilent Technologies, Inc., Santa Clara, CA 95051 (US)
(72) Inventor: LOCK, Herman, Wellington CO 80549 (US)
(74) Representative: Zimmermann, Tankred Klaus
(86) International application number: PCT/US2008/063310
(87) International publication number: WO 2009/094040

(56) References cited:
- JP-A- 7 039 539
- JP-A- 2007 275 164
- US-A- 4 694 255
- US-A- 4 939 465
- US-A- 5 483 163
- US-B1- 6 236 206
- US-B1- 6 396 271

## Description

### FIELD OF THE INVENTION

The present invention relates to a coil assembly for nuclear magnetic resonance (NHR) utilized for radio-frequency signal transmission and reception including a coil operated in quadrature. More particularly, the invention relates to frequency-tuning and quadrature-balancing such coils.

### BACKGROUND OF THE INVENTION

Coils of various designs have been utilized to transmit (send) and receive wireless signals, particularly radio-frequency (RF) signals in a wide variety of contexts, including nuclear magnetic resonance (NMR) spectrometry and magnetic resonance imaging (MRI). An NMR spectrometer or MRI apparatus typically includes RF transmitting/receiving electronics, a sample probe, and a source of a strong magnetic field in which the sample probe is immersed such as a superconducting magnet. The sample probe contains a liquid or solid sample or a biological (human or animal) subject and one or more RF coils that serve as the electromagnetic coupling between the RF electronics and the sample. The RF electronics are operated to irradiate the sample with RF energy and receive RF signals emitted from the sample in response to the RF input. The response signals are utilized to extract spectrometric or imaging information regarding the sample. The same coil may be employed to transmit and receive the RF energy, particularly in applications where RF input (excitation) and output (signal detection) occur at different times. Typically, the coil is cylindrical and surrounds the sample.

One popular coil utilized in NMR-related applications is commonly known as a birdcage coil. The typical birdcage coil consists of a cylindrical arrangement of 4, 8, 16 or 32 axially-oriented, parallel conductive legs (or fingers, rungs, etc.) evenly distributed about a central axis. The multiple of four in the number of legs facilitates quadrature operation. The legs typically extend between two conductive end loops (or rings). Increasing the number (and thus density) of the legs increases the homogeneity of the magnetic B₁ field applied by the coil. As the B₁ field oscillates at a desired resonant RF frequency, the current flowing through the legs approximates a sinusoidal-weighted distribution as one moves along polar angle positions from 0 to 360 degrees relative to the central axis of the cylindrical coil structure. A variation of the birdcage coil is the Millipede™ coil commercially available from Varian, Inc., Palo Alto, California. The Millipede™ coil includes a much larger number of legs (typically 200 or more). The increased density of legs in the Millipede™ coil increases the RF magnetic homogeneity exhibited by the coil.

The birdcage or Millipede™ coil can be driven linearly by coupling the RF transmit/receive electronics to a single leg of the coil via a single coaxial cable. To double the RF power efficiency during signal transmission and reduce the signal-to-noise ratio by a factor of √2 (about 1.41) during signal reception, the coil can be driven in quadrature by coupling the RF transmit/receive electronics to two legs of the coil located ninety degrees apart via two coaxial cables. In this case, the signals corresponding to the two orthogonal quadrature modes are ninety degrees out of phase relative to each other. The two detection signals are combined in a combiner circuit of the RF electronics and processed in a known manner.

To operate on nuclear magnetic resonant phenomena, the coil must be tuned to a resonant frequency dependent on the static magnetic B₀ field being applied and the nuclei being analyzed. The tuning must be accomplished in a manner that maintains the electrical symmetry of the coil, the homogeneity of the RF fields produced by the coil, and an acceptable level of signal-to-noise ratio. Moreover, once the coil has been tuned to a desired frequency, the subsequent loading of the sample to be analyzed in the core surrounded by the coil requires that the coil be retuned to the desired frequency because the resident sample causes detuning, a shift in the resonance frequency of the RF coil as seen by the operator. When operating in quadrature, both modes must be tuned to the same resonant frequency. Asymmetry in the sample loaded into the observation space within the coil, as well as asymmetry in the coil itself due to the limitations of manufacturing technology, cause quadrature imbalance and attendant problems such as lowered signal-to-noise ratio.

To effect the required tuning, approaches entailing the use of variable capacitors and discrete capacitors have been incorporated into birdcage-type coils that enable capacitances to be adjusted. In the case of Millipede™ coils, the capacitances defining the resonant frequency of the coil structure may be formed by overlapping conductive surfaces on either side of a dielectric substrate utilized as a coil former, thus producing an RF-transmitting structure having distributed capacitances. In one design, a tune ring consisting of a conductive element supported on a dielectric substrate is located at one end of a birdcage coil and is moved over the legs of the coil to vary capacitance and thereby adjust frequency. A variation of this design (see, e.g., US-B1-6 236 206) adds a second movable tune ring at the other axial end of the coil. The tune ring or rings enable the adjustment of capacitance of all legs, and thus the frequency of the coil, in a global manner. The effect of sample loading on the tuning of the coil is often on the order of a few percent, especially at frequencies of 400 MHz and up. The tuning range must be wide enough to enable the coil to be retuned to the desired frequency irrespective of the level of sample loading. Designs that employ global tuning mechanisms have generally resulted in relatively narrow tuning ranges. Mechanical tolerances and small asymmetries in the coil structure will lead to quadrature imbalances over the tuning range of the coil if larger variations in capacitance are called for to obtain the large tuning range. Accordingly, a coil, and particularly one with a global tuning mechanism, should have a mechanism to readjust the quadrature balance.

Accordingly, there is an acknowledged ongoing need for improvements in RF coil design, particularly in the design of coils operated in quadrature. In particular, there is a need for providing coils that can be tuned over a large frequency range while maintaining balanced quadrature modes.
US 6,236,206 B1 describes a birdcage coil that is globally tuned by a tuning structure to maintain constant RF phase shift for each leg conductor of the birdcage while containing a load. The birdcage coil may be globally tuned by adjusting the capacitances or inductances in a symmetrical manner.
US 4,939,465 A describes a probe head for nuclear magnetic resonance (NMR) measurements, in particular for use in NMR tomography.
US 4,694,255 A describes an NMR radio-frequency coil made up of a plurality of conductive segments evenly spaced about the peripheries and interconnecting a pair of conductive loop elements. Each conductive segment includes at least one reactive element which may include a variable capacitive or inductive element.
US 6,396,271 B1 describes a tunable radio frequency birdcage coil which has an improved tuning range for use with a magnetic resonance apparatus. The coil includes a pair of end ring conductors which are connected by a plurality of spaced leg conductors to form a generally cylindrical volume. Both the end rings and the leg conductors contain reactive elements. The radio frequency coil also includes a pair of tuning rings for tuning the reactive elements, which each include a non-conductive support cylinder and a plurality of tuning bands which extend axially along the outer surface of the support cylinder. The tuning rings are rotated or translated with respect to the leg conductors in order to vary capacitance and inductance of the coil to tune the coil to the desired resonant frequency.

### SUMMARY OF THE INVENTION

It is an object of the invention to provide an improvement in RF coil design, particularly in the design of a coil operated in quadrature that can be tuned over a large frequency range while maintaining balanced quadrature modes.
This object is achieved by a coil assembly of claim 1.

### BRIEF DESCRIPTION OF THE DRAWINGS

The invention can be better understood by referring to the following figures. The components in the figures are not necessarily to scale, emphasis instead being placed upon illustrating the principles of the invention. In the figures, like reference numerals designate corresponding parts throughout the different views.

Figure 1 is a perspective view of an example of a coil assembly according to one or more implementations taught in the present disclosure.

Figure 2 is an elevation view of another example of a coil assembly according to one or more implementations taught in the present disclosure.

Figure 3 is a top view of the coil assembly of Figure 2.

Figure 4 is a bottom view of the coil assembly of Figure 2.

Figure 5 is a cross-sectional view of an example of an arrangement of conductive and dielectric elements that may be utilized to adjust capacitance.

Figure 6 is a perspective view of another example of a coil assembly according to one or more implementations taught in the present disclosure.

Figure 7 is another perspective view of the coil assembly of Figure 6, rotated 180 degrees about a cylindrical axis.

Figure 8 is another perspective view of the coil assembly of Figure 6, rotated 90 degrees about a cylindrical axis.

Figure 9 is an elevation view of a portion of the coil assembly of Figure 6, illustrating the adjustment of capacitive shields according to an implementation taught in the present disclosure.

Figure 10 is another elevation view of the portion of the coil assembly illustrated in Figure 9.

Figure 11 is a perspective view of an example of a section of a coil assembly that includes user controls and adjustment mechanisms, according to an implementation taught in the present disclosure.

Figure 12 is a perspective view of an example of a mechanism that adjusts a tuning ring, according to an implementation taught in the present disclosure.

Figure 13 is a plan view of an example of a mechanism that adjusts capacitive shields, according to an implementation taught in the present disclosure.

### DETAILED DESCRIPTION OF THE INVENTION

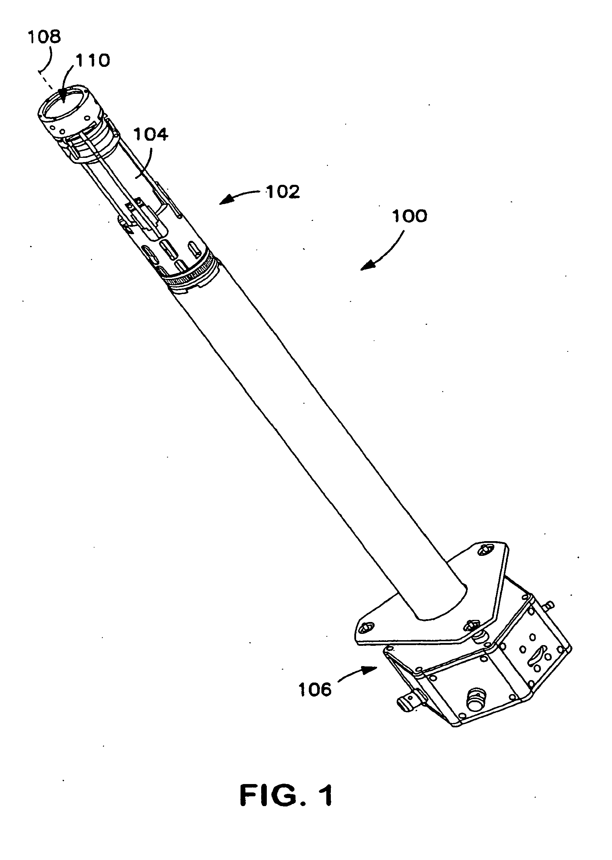

Figure 1 is a perspective view of an example of a coil assembly **100**. The coil assembly **100** may include a first section **102** supporting a coil structure **104** and a second section 106 containing other electrical and mechanical components. The first section **102** is generally arranged about a central longitudinal axis **108** and encloses a bore **110** into which a sample to be analyzed is introduced. The bore **110** may be continued through the second section **106**.

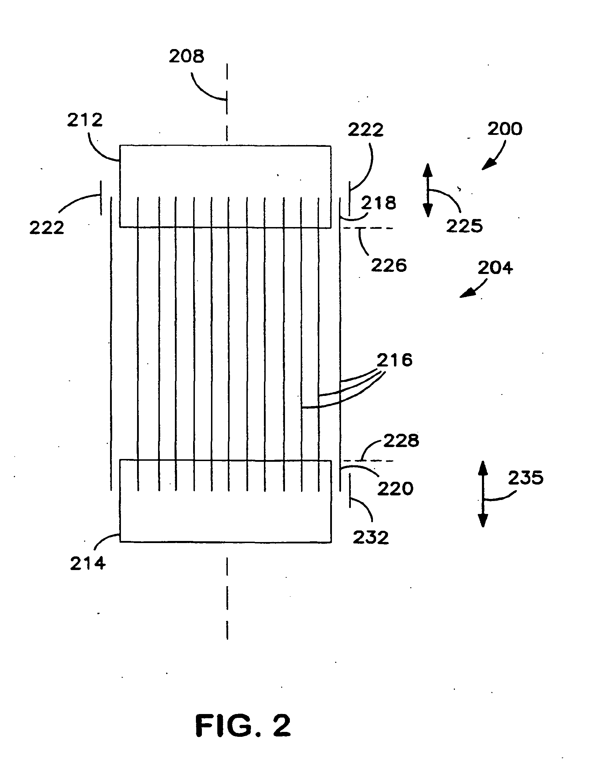

Figures 2-4 are simplified schematic views of an example of a coil assembly **200** and associated coil **204**. The structure of the coil **204** is generally arranged about a central longitudinal axis **208** and encloses an interior space into which a sample to be analyzed is introduced. The coil **204** generally includes a first end region and a second end region axially spaced from each other, and axial conductors extending between the first and second end regions. The coil **204** includes a first annular conductor **212** and a second annular conductor **214** disposed about the longitudinal axis **208** and axially spaced from each other. A plurality of axial conductors **216** is disposed in parallel with the longitudinal axis at a radial distance therefrom. The axial conductors **216** are circumferentially spaced from each other relative to the longitudinal axis **208.** In the illustrated example, the resulting geometry of the coil **204** is cylindrical. It will be understood, however, that the geometry of the coil **204** may deviate somewhat from a perfect cylinder or may have a different hollow form such as an elliptical shape. The axial conductors **216** terminate at respective first axial ends **218** and opposing second axial ends **220**. The first axial ends **218** are positioned in overlapping relation with the first annular conductor **212** at a radial distance from the first annular conductor **212** relative to the longitudinal axis **208**. The second axial ends **220** are positioned in overlapping relation with the second annular conductor **214** at a radial distance from the annular conductor **214** relative to the longitudinal axis **208**. The coil **204** is a birdcage-type coil. In some implementations the coil includes a large number of axial conductors **216** (e.g., about 200 or greater) such as in the case of the above-mentioned Millipede™ coil.

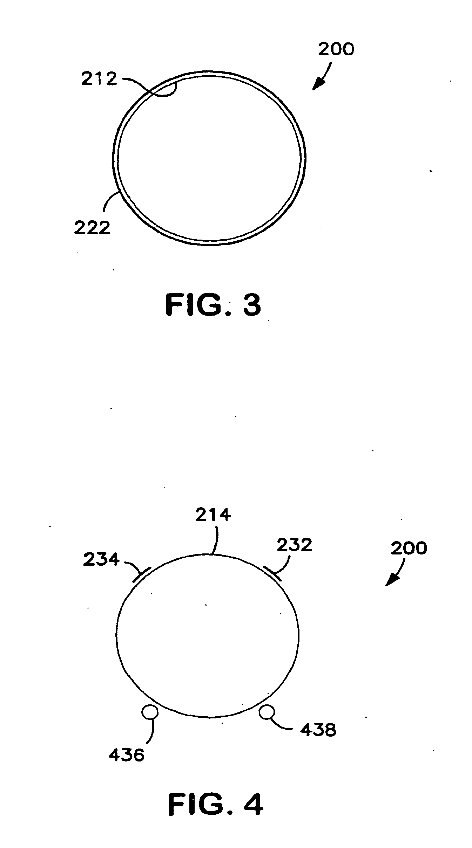

The coil assembly **200** in which the coil **204** is provided includes a capacitive tuning ring **222**. The tuning ring **222** is disposed about the longitudinal axis **208** in overlapping relation with the first axial ends **218** of the axial conductors and with the first annular conductor **212**, at a radial distance from these components relative to the longitudinal axis **208**. In Figure 2, the tuning ring **222** is schematically depicted by two lines to illustrate its position relative to the other components. In practice, the tuning ring **222** has a circumferentially complete annular structure such that the tuning ring **222** overlaps the first axial ends **218** of all axial conductors **216** (see Figure 3). The coil assembly **200** includes means for enabling the axial position of the tuning ring **222** to be adjusted relative to the fixed-position coil **204**, i.e., relative to the axial positions of the first annular conductor **212** and the axial conductors **216**. The axial mobility of the tuning ring **222** is depicted by an arrow **225**. The axial adjustability of the tuning ring **222** enables the amount of overlap between the tuning ring **222** and the first annular conductor **212** and the first axial ends **218** to be adjusted. As appreciated by persons skilled in the art, the adjustability enables the capacitive coupling between the first annular conductor **212** and the axial conductors **216** to be adjusted. Accordingly, the tuning ring **222** may be utilized for "rough" tuning the coil **204** over a large frequency range. The coil assembly **200** may be configured to limit adjustment of the tuning ring **222** such that the tuning ring **222** cannot extend into the field-of-view (FOV) presented by the coil structure and thus does not cause distortion of the images derived from RF signals acquired from the sample under observation. The FOV may generally be defined as the space occupied by the coil **204** axially extending between the first annular conductor **212** and the second annular conductor **214**, as depicted by boundary lines **226** and **228**.

As best shown in Figure 4, the coil assembly **200** also includes two capacitive shields **232** and **234**. As evident from Figure 2, each capacitive shield **232** and **234** is disposed about the longitudinal axis **208** in overlapping relation with a group of adjacent second axial ends **220** of the axial conductors **216** and with the second annular conductor **214**, at a radial distance from these components relative to the longitudinal axis **208**. Relative to the longitudinal axis **208**, the two capacitive shields **232** and **234** are offset ninety degrees from each other (Figure 4) and thus overlap with two different groups of adjacent second axial ends **220**. The coil assembly **200** includes means for enabling the axial positions of the capacitive shields **232** and **234** to be adjusted relative to the axial positions of the second annular conductor **214** and the respective groups of axial conductors **216**. The axial mobility of the capacitive shields **232** and **234** is depicted by an arrow **235** in Figure 2. The axial adjustability of the capacitive shields **232** and **234** enables the amount of overlap between the capacitive shields **232** and **234** and the second annular conductor **214** and respective groups of axial conductors **216** to be adjusted. This adjustability enables the capacitive coupling between the second annular conductor **214** and the axial conductors **216** to be adjusted. In comparison to the tuning ring **222**, the two ninety-degree offset capacitive shields **232** and **234** are small arcs (compare Figures 3 and 4). Thus, the axial adjustment of one capacitive shield **232** or **234** will affect the frequency tuning of one quadrature mode only. By this configuration, the capacitive shields **232** and **234** are utilized as a quadrature balance "fine" tuning mechanism that restores the quadrature balance between the two quadrature modes caused by asymmetry in the coil **204**, the sample, and/or the rough-tune tuning ring **222**. Like the tuning ring **222**, the coil assembly **200** may be configured to limit adjustment of the capacitive shields **232** and **234** such that the capacitive shields **232** and **234** cannot extend into the field-of-view (FOV) presented by the coil structure. As described in more detail below, the coil assembly **200** is configured to adjust the capacitive shields **232** and **234** in a differential fashion.

Figure 3 schematically illustrates a top view of the coil assembly **200**. From the perspective of Figure 3, the first annular conductor **212** of the coil is visible. The tuning ring **222** surrounds the first annular conductor **212** and the proximate ends of the axial conductors (not shown) of the coil, thereby enabling simultaneous rough tuning of both quadrature channels.

Figure 4 schematically illustrates a bottom view of the coil assembly **200**. From the perspective of Figure 4, the second annular conductor **214** of the coil is visible. The two capacitive shields **232** and **234** are located ninety degrees from each other in accordance with a quadrature mode of operation of the coil. The two capacitive shields **232** and **234** overlap the second annular conductor **214** and two different groups of axial conductors (not shown) as noted above. Figure 4 also illustrates the positions of two impedance-matching circuits **436** and **438** corresponding to the two quadrature channels. In practice, two RF transmission lines (e.g., 50-Ω coaxial cables) are coupled to the coil at the respective matching circuits **436** and **438**. The two matching circuits **436** and **438** communicate with the coil at locations 180 degrees from the two capacitive shields **432** and **434**, respectively. The matching circuits **436** and **438** may include variable capacitors and other components useful for impedance matching as appreciated by persons skilled in the art. In one example, the variable capacitors of the matching circuits **436** and **438** may be adjustable by axially moving the capacitors or a component of the capacitors.

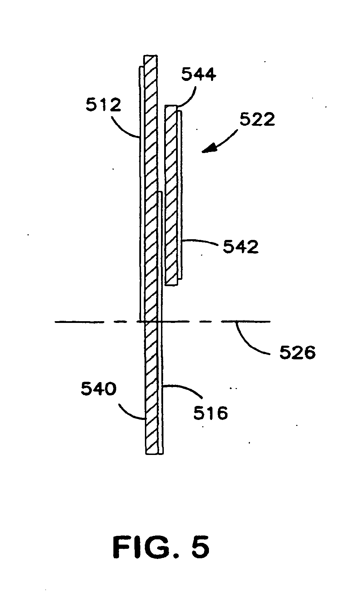

Figure 5 is a cross-sectional view of an example of an arrangement of capacitive elements that may be realized in a coil assembly. Specifically, Figure 5 illustrates the respective radial positions of a first annular conductor **512** of a coil, an axial conductor **516** of the coil, and a tuning ring **522**. By way of example, the annular conductor **512** and the axial conductors **516** may be fabricated by known fabrication techniques on a coil former **540** such as a flexible circuit board composed of a dielectric material. The axially movable tuning ring **522** may similarly include a conductive portion **542** supported by a dielectric substrate **544**. The conductive portions of the annular conductor **512**, the axial conductors **516** and the tuning ring **522** may be composed of, for example, copper, gold, silver, platinum, or any other suitable electrically conductive material. For reference purposes, Figure 5 illustrates an upper boundary **526** of the FOV of the resulting coil. Figure 5 is also analogously representative of the respective radial positions of a second annular conductor, axial conductors, and capacitive shields located at the opposite end of the coil.

In the example illustrated in Figure 5, the axial conductors **516** are located radially outward of the annular conductors **512**. That is, the axial conductors **516** are located at a greater radial distance from the longitudinal axis of the coil than the annular conductors **512**. The tuning ring **522** in turn is located radially outward of the axial conductors **516**. The relative radial positions of these components may be changed in other implementations.

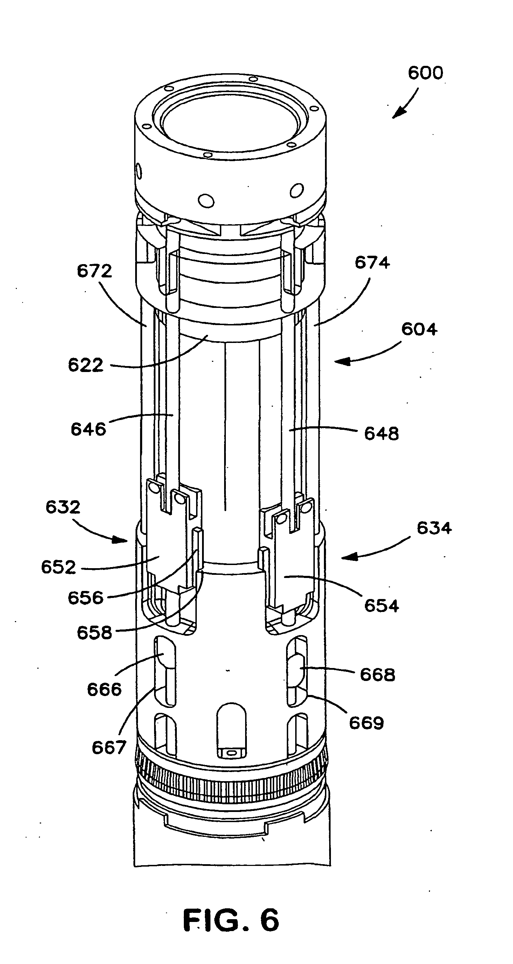

Figure 6 is a perspective view of another example of a coil assembly **600**. The coil assembly **600** includes means for moving or guiding the axial movement of two capacitive shields **632** and **634** relative to a coil **604**. In the illustrated example, the coil assembly **600** includes two elongate members **646** and **648** located ninety degrees apart that respectively support the axial movement of the two capacitive shields **632** and **634**. As an example, the elongate members **646** and **648** may be threaded rods that are free to rotate about their respective axes but are axially fixed in their positions illustrated in Figure 6. The capacitive shields **632** and **634** may include carriages **652** and **654** supporting the conductive portions of the capacitive shields **632** and **634**. The carriages **652** and **654** may include threaded portions that engage the threaded rods **646** and **648**. By this configuration, rotation of the rods **646** and **648** actuates the movement of the capacitive shields **632** and **634** axially up and down relative to the coil **604**. To maintain proper alignment of the capacitive shields **632** and **634**, the carriages **652** and **654** may include one or more tongues **656** extending in parallel with the axial direction of movement. The tongues **656** are guided in corresponding grooves or recesses **658** formed in a portion of the coil assembly **600**. The coil assembly **600** may also include means for limiting the axial movement of the capacitive shields **632** and **634**, such as stop mechanisms. In the illustrated example, the coil assembly **600** includes stop members **666** and **668** linked to the respective capacitive shields **632** and **634**. The stop members **666** and **668** move axially within respective openings (e.g., slots) **667** and **669**. Contact between the stop members **666** and **668** and upper and lower edges of their respective slots **667** and **669** provides upper and lower limits to the axial excursions of the capacitive shields **632** and **634**.

As also illustrated in Figure 6, the coil assembly **600** may include one or more other threaded rods **672** and **674** or other types of elongate members that support the axial adjustment of a tuning ring **622**. The tuning ring **622** may likewise be coupled to the threaded rods **672** and **674** such that rotation of the threaded rods **672** and **674** drives the tuning ring **622** axially upward or downward. When two such rods **672** and **674** are provided, they may be located 180 degrees apart as illustrated in the example. At the present time, it has been found that the illustrated arrangement of two rods **672** and **674** facilitates the adjustment of the tuning ring **622** in a precise manner that maintains the proper alignment of the tuning ring **622** relative to other components of the coil **604** and associated coil assembly **600**.

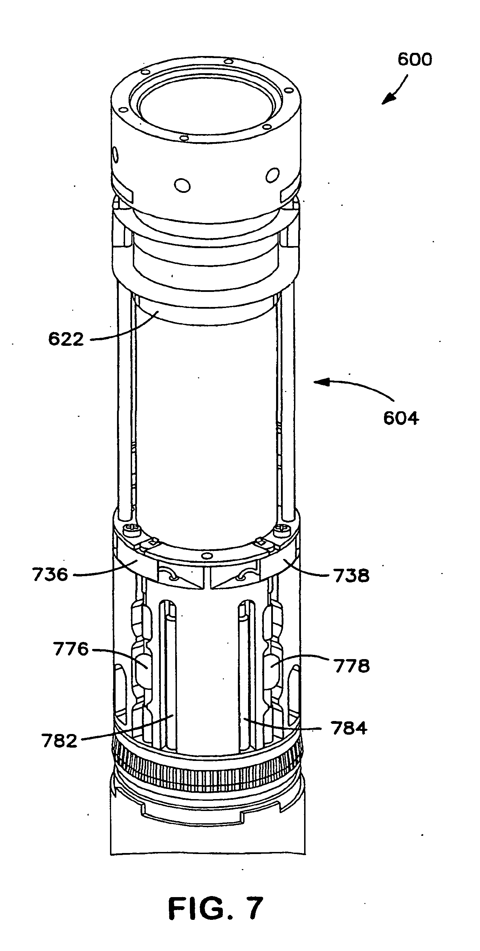

Figure 7 is another perspective view of the coil assembly **600** illustrated in Figure 6, rotated 180 degrees about the longitudinal axis. Two matching circuits **636** and **638** are located ninety degrees apart and 180 degrees away from the respective capacitive shields **632** and **634** (Figure 6). The matching circuits **736** and **738** include respective variable capacitors. These capacitors (or components thereof) may be axially adjustable. Stop members **776** and **778** moving in corresponding slots may be provided to limit the axial movements of the variable capacitors, respectively. Figure 7 also illustrates two transmission lines **782** and **784** respectively coupled to the matching circuits **736** and **738**.

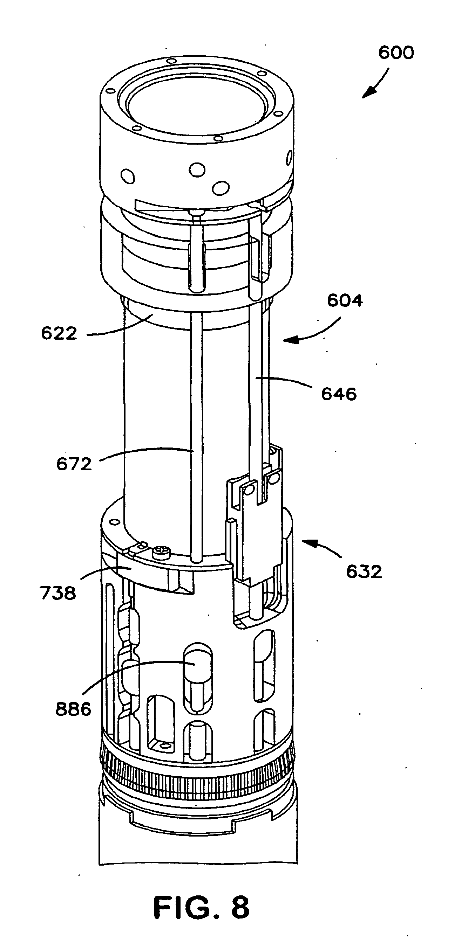

Figure 8 is another perspective view of the coil assembly **600** illustrated in Figure 6, rotated 90 degrees about the longitudinal axis such that one capacitive shield **632** and one matching circuit **738** are visible. One of the threaded rods **672** supporting the axial adjustment of the tuning ring **622** is also visible. A stop member **886** moving in a slot may be provided to limit the axial movement of the tuning ring **622**. Another stop member and corresponding slot may also be provided to limit the axial movement of the tuning ring **622** from the other side.

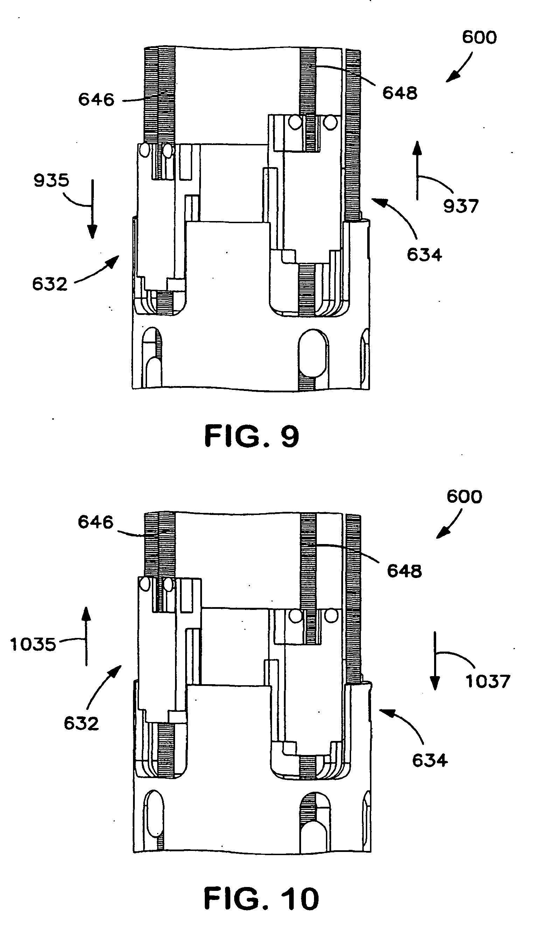

Figures 9 and 10 are perspective views of the section of the coil assembly **600** illustrated in Figure 6 that includes the two capacitive shields **632** and **634**. According to an implementation of the present disclosure, the capacitive shields **632** and **634** may be driven in a differential fashion by which a single fine-tuning adjustment made by a user will cause the capacitive shields **632** and **634** to move relative to each other in a manner effective to restore quadrature balance. To this end, the coil assembly **600** is configured such that making an adjustment will actuate one capacitive shield **632** or **634** to move up while simultaneously actuating the other capacitive shield **634** or **632** to move down. Consequently, the frequency of one quadrature mode is increased while the frequency of the orthogonal mode is decreased. The single adjustment made by the user may be realized by providing a single input device, such as a knob, dial, wheel or lever, etc., and associated mechanical linkages between the single input device and the threaded rods **646** and **648** on which the capacitive shields **632** and **634** respectively travel. Thus, in Figure 9 for example, moving (e.g., sliding, turning, rotating, etc.) the input device in one direction moves the first capacitive shield **632** down and simultaneously moves the second capacitive shield **634** up, as indicated by respective arrows **935** and **937**. Likewise in Figure 10, moving the input device in the opposite direction moves the first capacitive shield **632** up and simultaneously moves the second capacitive shield **634** down, as indicated by respective arrows **1035** and **1037**.

In other implementations, the coil assembly **600** may be configured to enable each capacitive shield **632** and **634** to be adjusted separately and independently of the other. Such a configuration, however, would require the user to make two adjustments that must be precisely coordinated to correctly balance the coil **604**. A properly configured arrangement as described above and illustrated in Figures 9 and 10 eliminates the need for making independent adjustments to the two capacitive shields **632** and **634**.

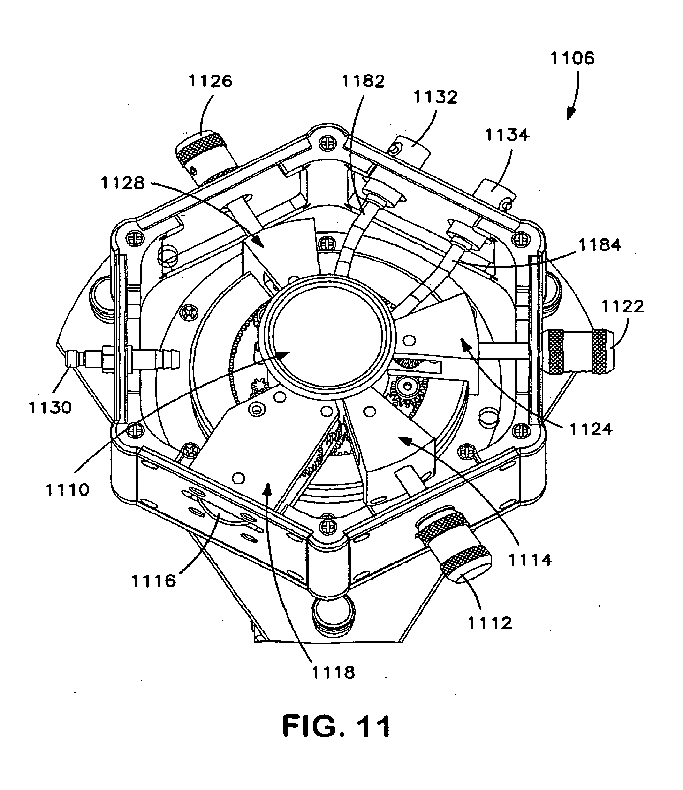

Figure 11 is a bottom perspective view of an example of a section **1106** of a coil assembly that may be included to provide user controls and adjustment mechanisms utilized to effect the adjustment of a tuning ring, capacitive shields, and match circuits as described above. The adjustment mechanisms may include suitable linkages (gears, etc.) to these adjustable components. The linkages may be actuated by any suitable input means, such as user-actuated inputs (knobs, wheels, levers or the like) or automated devices (solenoids, etc.). In the illustrated example an adjustment knob **1112** is coupled to a mechanism **1114** for adjusting the tuning ring, an adjustment wheel **1116** is coupled to a mechanism **1118** for adjusting the capacitive shields in a differential fashion, an adjustment knob **1122** is coupled to a mechanism **1124** for adjusting the first matching circuit associated with the first quadrature channel, and an adjustment knob **1126** is coupled to a mechanism **1128** for adjusting the second matching circuit associated with the second, perpendicular quadrature channel. The adjustment mechanisms **1114**, **1118**, **1124**, **1128** are coaxially situated about a central bore **1110** of the coil assembly in which a sample to be imaged is introduced. Figure 11 also illustrates a fitting **1130** utilized for gas purging, and feed-throughs **1132** and **1134** for routing coaxial cables **1182** and **1184** to appropriate connection points on the coil for quadrature operation.

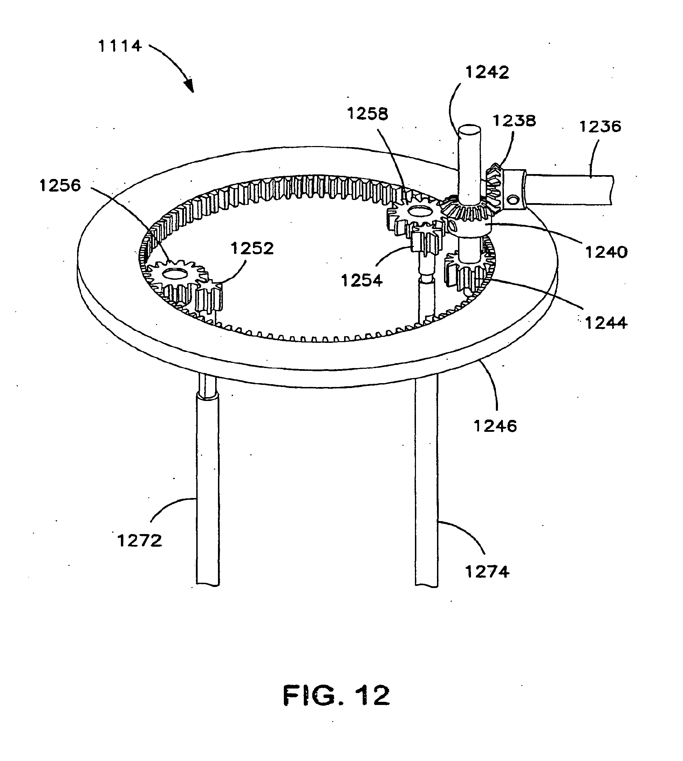

Figure 12 illustrates an example of the mechanism **1114** for adjusting the tuning ring. The adjustment mechanism **1114** may be housed in a section of the coil assembly such as illustrated in Figure 11. In the illustrated example, the adjustment mechanism **1114** generally includes a gear train that couples the adjustment knob **1112** (see, e.g., Figure 11) with a pair of threaded rods. The gear train is configured such that rotation of the adjustment knob **1112** causes both threaded rods **1272** and **1274** to rotate in the same direction, thereby causing a tuning ring coupled to the threaded rods **1272** and **1274** to move axially up or down relative to a coil as described above. In the specific example, a shaft **1236** extending from the adjustment knob **1112** into this section of the coil assembly is coupled to a bevel gear **1238**. The bevel gear **1238** is coupled to another bevel gear **1240** mounted on a shaft **1242** oriented perpendicularly to the first shaft **1236**. Rotation of the shaft **1236** of the adjustment knob **1112** thus rotates the second shaft **1242**, which in turn rotates a spur gear **1244** attached to the second shaft **1242**. The spur gear **1244** is coupled to teeth formed on the inside of a ring **1246**. Rotation of the toothed ring **1246** simultaneously rotates respective pinion gears **1252** and **1254** mounted on the threaded rods **1272** and **1274**, thereby rotating the threaded rods **1272** and **1274**. One or more pairs of intermediate gears **1256** and **1258** mounted on fixed posts or shafts and coupled between the toothed ring **1246** and the pinion gears **1252** and **1254** may be provided.

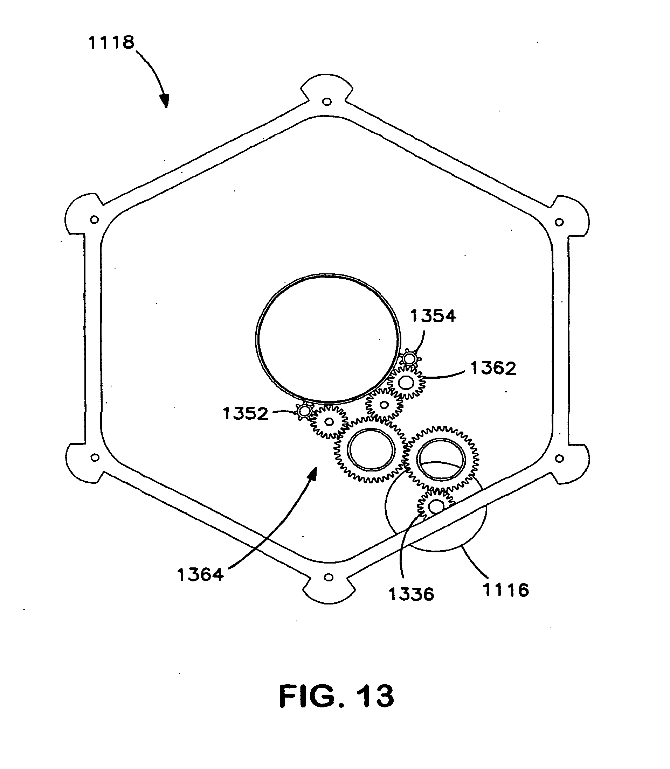

Figure 13 illustrates an example of the mechanism **1118** for adjusting the capacitive shields in the above-described differential fashion. The adjustment mechanism **1118** may be housed in a section of the coil assembly such as illustrated in Figure 11. In the illustrated example, the adjustment mechanism **1118** generally includes a gear train that couples the adjustment wheel **1116** with a pair of threaded rods. The threaded rods may be coupled to the respective capacitive shields in any suitable manner, one example being through the use of carriages such as described above and illustrated in Figure 6. The gear train is configured such that rotation of the adjustment wheel **1116** causes the threaded rods to rotate in opposite directions, thereby causing one capacitive shield to move axially up and the other capacitive shield to move axially down at the same time, as described above. In the specific example, the adjustment wheel **1116** is coupled to a spur gear **1336**. The spur gear **1336** is coupled to a pinion gear **1352** mounted on one of the threaded rods and to an additional gear **1362** that is in turn coupled to a pinion gear **1354** mounted on the other threaded rod. The coupling between the spur gear **1336** of the adjustment wheel **1116** and the first pinion gear **1352** and additional gear **1362** may be effected through one or more intermediate gears **1364** as necessary. The additional gear **1362** coupled to the second pinion gear **1354** operates to rotate the second pinion gear **1354** in a direction opposite to the first pinion gear **1352**. Accordingly, rotation of the adjustment wheel **1116** in a given direction causes the first threaded rod to rotate in one direction and the second threaded rod to rotate simultaneously in the opposite direction.

From the foregoing description, it can be seen that implementations taught in the present disclosure enable a coil to be tuned over a large frequency range while maintaining balanced quadrature modes. Implementations of the coil assembly provide a capacitive tuning ring that rough-tunes the quadrature modes simultaneously albeit not always equally. Implementations of the coil assembly provide two small capacitive shields offset ninety degrees apart in correspondence with two quadrature modes. The capacitive shields enable fine tuning of both quadrature modes so that the quadrature balance may be adjusted, thereby retuning both modes to the same frequency.

Implementations taught in the present disclosure are applicable to magnetic resonance technology and the acquisition of spectroscopic and/or imaging data. Accordingly, the coils and associated coil assemblies taught herein may be utilized in nuclear magnetic resonance (NMR) and magnetic resonance imaging (MRI) applications.

In general, the term "communicate" (for example, a first component "communicates with" or "is in communication with" a second component) is used herein to indicate a structural, functional, mechanical, electrical, optical, magnetic, ionic or fluidic relationship between two or more components or elements. As such, the fact that one component is said to communicate with a second component is not intended to exclude the possibility that additional components may be present between, and/or operatively associated or engaged with, the first and second components.

## Claims

1. A radio frequency (RF) coil assembly (100, 200) for nuclear magnetic resonance, the coil assembly including a coil for transmitting and/or receiving RF signals and providing for global frequency tuning and quadrature-balancing the coil, the coil assembly comprising:
a generally cylindrical birdcage-type coil (204) enclosing an interior space for the introduction of a sample to be analyzed, the coil (204) including
a first annular conductor (212) and a second annular conductor (214) disposed about a central longitudinal axis (208) of the coil and axially spaced from each other, and
a plurality of parallel axial conductive legs (216) extending between the first annular conductor (212) and the second annular conductor (214) in parallel to the longitudinal axis (208) and circumferentially spaced from each other about the longitudinal axis (208), the axial conductive legs (216) terminating at respective first axial ends (218) and opposing second axial ends (220), wherein the first axial ends (218) are positioned in overlapping relation with the first annular conductor (212) at a radial distance from the first annular conductor (212) relative to the longitudinal axis (208) so as to be capacitively coupled with the first annular conductor, wherein the second axial ends (220) are positioned in overlapping relation with the second annular conductor (214) at a radial distance from the second annular conductor (214) relative to the longitudinal axis (208) so as to be capacitively coupled with the second annular conductor (214); and
a capacitive tuning ring (222) for adjusting the capacitive coupling between the first annular conductor (212) and the axial conductive legs (216), the capacitive tuning ring (222) being disposed about the longitudinal axis (208) in overlapping relation with the first axial ends (218) of the axial conductive legs (216) and with the first annular conductor (212), at a radial distance from the first axial ends (218) of the axial conductive legs (216) and the first annular conductor (212) relative to the longitudinal axis (208), the tuning ring (222) being axially movable relative to the coil whereby the amount by which the tuning ring axially overlaps the first axial ends (218) of the axial conductive legs (216) and the first annular conductor (212), respectively, is adjustable for global tuning of the coil;
a first capacitive shield (232) and a second capacitive shield (234), the first and second capacitive shields (232, 234) being disposed about the longitudinal axis and axially overlapping the second annular conductor (214) and the second axial ends (220) of two respectively different groups of circumferentially adjacent axial conductive legs (216),
wherein the first capacitive shield (232) is for adjusting the capacitive coupling between the second annular conductor (214) and the second axial ends (220) of the axial conductive legs (216) of a first group of circumferentially adjacent axial conductive legs, the first capacitive shield (232) being disposed in axially overlapping relationship with the second annular conductor (214), on the one hand, and with the second axial ends (220) of the axial conductive legs (216) of the first group of axial conductive legs, on the other hand, at a radial distance from the second annular conductor (214) and the second axial ends (220) of the axial conductive legs (216) of the first group of axial conductive legs, and the first capacitive shield being axially movable relative to the first group of axial conductive legs and to the second annular conductor (214), whereby the amount by which the first capacitive shield (232) axially overlaps the second annular conductor (214) and the second axial ends (220) of the axial conductive legs (216) of the first group of axial conductive legs, respectively, is adjustable,
wherein the second capacitive shield (234) is for adjusting the capacitive coupling between the second annular conductor (214) and the second axial ends (220) of the axial conductive legs (216) of a second group of circumferentially adjacent axial conductive legs, the second capacitive shield (234) being circumferentially offset ninety degrees from the first capacitive shield (232) relative to the longitudinal axis (208), the second capacitive shield (234) being disposed in axially overlapping relationship with the second annular conductor (214), on the one hand, and with the second axial ends (220) of the axial conductive legs (216) of the second group of axial conductive legs, on the other hand, at a radial distance from the second annular conductor (214) and the second axial ends (220) of the axial conductive legs (216) of the second group of axial conductive legs, and the second capacitive shield being axially movable relative to the second group of axial conductive legs and to the second annular conductor (214), whereby the amount by which the second capacitive shield (234) axially overlaps the second annular conductor (214) and the second axial ends (220) of the axial conductive legs (216) of the second group of axial conductive legs, respectively, is adjustable, and wherein
the two capacitive shields (232, 234) are movable relative to each other along the axial direction for adjusting the quadrature balance of the coil whereby the adjustment of the axial position of the first capacitive shield and the adjustment of the axial position of the second capacitive shield provides a mechanism for fine tuning of a respectively different one of the two orthogonal modes of a quadrature mode of operation of the coil.

2. The coil assembly of claim 1, wherein:
in comparison to the tuning ring (222), the two ninety-degree offset capacitive shields (232, 234) are small arcs so that the axial adjustment of one capacitive shield (232, 234) will affect the frequency tuning of one quadrature mode only.

3. The coil assembly of claim 1, wherein the plurality of axial conductive legs (216) is disposed at a greater radial distance from the longitudinal axis (208) than the first annular conductor (212) and the second annular conductor (214), the tuning ring (222) is disposed at a greater radial distance from the longitudinal axis than the plurality of axial conductive legs (216), and the first capacitive shield (232) and the second capacitive shield (234) are disposed at a greater radial distance from the longitudinal axis than the plurality of axial conductive legs.

4. The coil assembly of claim 1, further including an adjustment mechanism (1114, 1118, 1124, 1128) including a linkage coupled to the first capacitive shield (232) and the second capacitive shield (234), the linkage configured to move the first capacitive shield and the second capacitive shield simultaneously in opposite axial directions in response to an actuating input to the linkage

5. The coil assembly of claim 1, further including an adjustment mechanism coupled to the first capacitive shield (232) and the second capacitive shield (234) and configured to move the first capacitive shield and the second capacitive shield individually.

6. The coil assembly of claim 1, further including a first elongate member (646) and a second elongate member (648) disposed in parallel with the longitudinal axis (208), wherein the first capacitive shield (232, 632) is movably coupled to the first elongate member and the second capacitive shield (234, 634) is movably coupled to the second elongate member.

7. The coil assembly of claim 6, wherein the, first elongate member (646) includes a threaded portion, the first capacitive shield (232, 632) includes a threaded portion engaging the threaded portion of the first elongate member, the second elongate member (648) includes a threaded portion, the second capacitive shield (234, 634) includes a threaded portion engaging the threaded portion of the second elongate member, and rotation of the first elongate member moves the first capacitive shield and rotation the second elongate member moves the second capacitive shield.

8. The coil assembly of claim 1, further including stop mechanisms for limiting the axial movement of the capacitive shields, the stop mechanisms including a first stop mechanism linked to the first capacitive shield and a second stop mechanism linked to the second capacitive shield.

9. The coil assembly of claim 1, further including a first impedance-matching circuit (736) communicating with the coil (604) at a point 180 degrees offset from the first capacitive shield (632) relative to the longitudinal axis (208), and a second impedance-matching circuit (738) communicating with the coil (604) at a point 180 degrees offset from the second capacitive shield (634).

## Patentansprüche

1. Ein Hochfrequenz(HF)-Spulensatz (100, 200) für kernmagnetische Resonanz, wobei der Spulensatz eine Spule zum Senden und/oder Empfangen von HF-Signalen und zum Bereitstellen einer Globalfrequenzabstimmung und eines Quadraturausgleichs der Spule umfasst, wobei der Spulerisatz folgende Merkmale aufweist:
eine allgemein zylindrische Spule vom Vogelkäfigtyp (204), die einen Innenraum für die Einführung einer zu analysierenden Probe umschließt, wobei die Spule (204) folgende Merkmale umfasst:
einen ersten ringförmigen Leiter (212) und einen zweiten ringförmigen Leiter (214), die um eine zentrale Längsachse (208) der Spule herum angeordnet und axial voneinander beabstandet sind, und
eine Mehrzahl von parallelen axialen leitfähigen Schenkeln (216), die sich zwischen dem ersten ringförmigen Leiter (212) und dem zweiten ringförmigen Leiter (214) parallel zu der Längsachse (208) erstrecken und um die Längsachse (208) herum umfangsmäßig voneinander beabstandet sind, wobei die axialen leitfähigen Schenkel (216) an jeweiligen ersten axialen Enden (218) und gegenüberliegenden zweiten axialen Enden (220) enden, wobei die ersten axialen Enden (218) in überlappender Beziehung zu dem ersten ringförmigen Leiter (212) in einem radialen Abstand von dem ersten ringförmigen Leiter (212) relativ zu der Längsachse (208) positioniert sind, um mit dem ersten ringförmigen Leiter kapazitiv gekoppelt zu werden, wobei die zweiten axialen Enden (220) in überlappender Beziehung zu dem zweiten ringförmigen Leiter (214) in einem radialen Abstand von dem zweiten ringförmigen Leiter (214) relativ zu der Längsachse (208) positioniert sind, um mit dem zweiten ringförmigen Leiter (214) kapazitiv gekoppelt zu werden; und
einen Kapazitivabstimmring (222) zum Anpassen der kapazitiven Kopplung zwischen dem ersten ringförmigen Leiter (212) und den axialen leitfähigen Schenkeln (216), wobei der Kapazitivabstimmring (222) um die Längsachse (208) herum in überlappender Beziehung zu den ersten axialen Enden (218) der axialen leitfähigen Schenkel (216) und mit dem ersten ringförmigen Leiter (212), in einem radialen Abstand von den ersten axialen Enden (218) der axialen leitfähigen Schenkel (216) und dem ersten ringförmigen Leiter (212) relativ zu der Längsachse (208) angeordnet ist, wobei der Abstimmring (222) relativ zu der Spule axial beweglich ist, wodurch das Ausmaß, in dem der Abstimmring die ersten axialen Enden (218) der axialen leitfähigen Schenkel (216) beziehungsweise den ersten ringförmigen Leiter (212) axial überlappt, zum Globalabstimmen der Spule anpassbar ist;
eine erste kapazitive Abschirmung (232) und eine zweite kapazitive Abschirmung (234), wobei die erste und die zweite kapazitive Abschirmung (232, 234) um die Längsachse herum angeordnet sind und den zweiten ringförmigen Leiter (214) und die zweiten axialen Enden (220) zweier jeweils unterschiedlicher Gruppen von umfangsmäßig benachbarten axialen leitfähigen Schenkeln (216) axial überlappen,
wobei die erste kapazitive Abschirmung (232) zum Anpassen der kapazitiven Kopplung zwischen dem zweiten ringförmigen Leiter (214) und den zweiten axialen Enden (220) der axialen leitfähigen Schenkel (216) einer ersten Gruppe von umfangsmäßig benachbarten axialen leitfähigen Schenkeln gedacht ist, wobei die erste kapazitive Abschirmung (232) in einer axial überlappenden Beziehung einerseits zu dem zweiten ringförmigen Leiter (214) und andererseits zu den zweiten axialen Enden (220) der axialen leitfähigen Schenkel (216) der ersten Gruppe von axialen leitfähigen Schenkeln in einem radialen Abstand von dem zweiten ringförmigen Leiter (214) und den zweiten axialen Enden (220) der axialen leitfähigen Schenkel (216) der ersten Gruppe von axialen leitfähigen Schenkeln angeordnet ist und wobei die erste kapazitive Abschirmung relativ zu der ersten Gruppe von axialen leitfähigen Schenkeln und zu dem zweiten ringförmigen Leiter (214) axial beweglich ist, wodurch das Ausmaß, in dem die erste kapazitive Abschirmung (232) den zweiten ringförmigen Leiter (214) beziehungsweise die zweiten axialen Enden (220) der axialen leitfähigen Schenkel (216) der ersten Gruppe von axialen leitfähigen Schenkeln axial überlappt, anpassbar ist,
und wobei die zweite kapazitive Abschirmung (234) zum Anpassen der kapazitiven Kopplung zwischen dem zweiten ringförmigen Leiter (214) und den zweiten axialen Enden (220) der axialen leitfähigen Schenkel (216) einer zweiten Gruppe von umfangsmäßig benachbarten axialen leitfähigen Schenkeln gedacht ist, wobei die zweite kapazitive Abschirmung (234) umfangsmäßig um neunzig Grad von der ersten kapazitiven Abschirmung (232) relativ zu der Längsachse (208) versetzt ist, wobei die zweite kapazitive Abschirmung (234) in einer axial überlappenden Beziehung einerseits zu dem zweiten ringförmigen Leiter (214) und andererseits zu den zweiten axialen Enden (220) der axialen leitfähigen Schenkel (216) der zweiten Gruppe von axialen leitfähigen Schenkeln in einem radialen Abstand von dem zweiten ringförmigen Leiter (214) und den zweiten axialen Enden (220) der axialen leitfähigen Schenkel (216) der zweiten Gruppe von axialen leitfähigen Schenkeln angeordnet ist und wobei die zweite kapazitive Abschirmung relativ zu der zweiten Gruppe von axialen leitfähigen Schenkeln und zu dem zweiten ringförmigen Leiter (214) axial beweglich ist, wodurch das Ausmaß, in dem die zweite kapazitive Abschirmung (234) den zweiten ringförmigen Leiter (214) beziehungsweise die zweiten axialen Enden (220) der axialen leitfähigen Schenkel (216) der zweiten Gruppe von axialen leitfähigen Schenkeln axial überlappt, anpassbar ist, und wobei
die zwei kapazitiven Abschirmungen (232, 234) entlang der axialen Richtung relativ zueinander bewegbar sind, um den Quadraturausgleich der Spule anzupassen, wodurch die Anpassung der axialen Position der ersten kapazitiven Abschirmung und die Anpassung der axialen Position der zweiten kapazitiven Abschirmung einen Mechanismus zum Feinabstimmen eines jeweils anderen der zwei orthogonalen Modi eines Quadratur-Betriebsmodus der Spule liefert.

2. Der Spulensatz gemäß Anspruch 1, bei dem:
im Vergleich zu dem Abstimmring (222) die zwei um neunzig Grad versetzten kapazitiven Abschirmungen (232, 234) kleine Bögen sind, sodass die axiale Anpassung einer kapazitiven Abschirmung (232, 234) die Frequenzabstimmung lediglich eines Quadraturmodus beeinflusst.

3. Der Spulensatz gemäß Anspruch 1, bei dem die Mehrzahl von axialen leitfähigen Schenkeln (216) in einem größeren radialen Abstand von der Längsachse (208) angeordnet sind als der erste ringförmige Leiter (212) und der zweite ringförmige Leiter (214), wobei der Abstimmring (222) in einem größeren radialen Abstand von der Längsachse angeordnet ist als die Mehrzahl von axialen leitfähigen Schenkeln (216), und die erste kapazitive Abschirmung (232) und die zweite kapazitive Abschirmung (234) in einem größeren radialen Abstand von der Längsachse angeordnet sind als die Mehrzahl von axialen leitfähigen Schenkeln.

4. Der Spulensatz gemäß Anspruch 1, der ferner einen Anpassungsmechanismus (1114, 1118, 1124, 1128) umfasst, der eine mit der ersten kapazitiven Abschirmung (232) und der zweiten kapazitiven Abschirmung (234) gekoppelte Verbindung umfasst, wobei die Verbindung dazu konfiguriert ist, die erste kapazitive Abschirmung und die zweite kapazitive Abschirmung ansprechend auf eine Betätigungseingabe in die Verbindung gleichzeitig in entgegengesetzte axiale Richtungen zu bewegen.

5. Der Spulensatz gemäß Anspruch 1, der ferner einen Anpassungsmechanismus umfasst, der mit der ersten kapazitiven Abschirmung (232) und der zweiten kapazitiven Abschirmung (234) gekoppelt ist und dazu konfiguriert ist, die erste kapazitive Abschirmung und die zweite kapazitive Abschirmung individuell zu bewegen.

6. Der Spulensatz gemäß Anspruch 1, der ferner ein erstes längliches Bauglied (646) und ein zweites längliches Bauglied (648) umfasst, die parallel zu der Längsachse (208) angeordnet sind, wobei die erste kapazitive Abschirmung (232, 632) bewegbar mit dem ersten länglichen Bauglied gekoppelt ist und die zweite kapazitive Abschirmung (234, 634) bewegbar mit dem zweiten länglichen Bauglied gekoppelt ist.

7. Der Spulensatz gemäß Anspruch 6, bei dem das erste längliche Bauglied (646) einen Gewindeabschnitt umfasst, die erste kapazitive Abschirmung (232, 632) einen Gewindeabschnitt umfasst, der den Gewindeabschnitt des ersten länglichen Bauglieds in Eingriff nimmt, das zweite längliche Bauglied (648) einen Gewindeabschnitt umfasst, die zweite kapazitive Abschirmung (234, 634) einen Gewindeabschnitt umfasst, der den Gewindeabschnitt des zweiten länglichen Bauglieds in Eingriff nimmt, und eine Drehung des ersten länglichen Bauglieds die erste kapazitive Abschirmung bewegt und eine Drehung des zweiten länglichen Bauglieds die zweite kapazitive Abschirmung bewegt.

8. Der Spulensatz gemäß Anspruch 1, der ferner Anschlagmechanismen zum Begrenzen der axialen Bewegung der kapazitiven Abschirmungen umfasst, wobei die Anschlagmechanismen einen ersten Anschlagmechanismus, der mit der ersten kapazitiven Abschirmung verbunden ist, und einen zweiten Anschlagmechanismus, der mit der zweiten kapazitiven Abschirmung verbunden ist, umfassen.

9. Der Spulensatz gemäß Anspruch 1, der ferner eine erste Impedanzanpassungsschaltung (736), die mit der Spule (604) an einen Punkt kommuniziert, der von der ersten kapazitiven Abschirmung (632) relativ zu der Längsachse (208) um hundertachtzig Grad versetzt ist, und eine zweite Impedanzanpassungsschaltung (738), die mit der Spule (604) an einem Punkt kommuniziert, der von der zweiten kapazitiven Abschirmung (634) um 180 Grad versetzt ist, umfasst.

## Revendications

1. Ensemble de bobine (100, 200) à radiofréquence (RF) pour résonance magnétique nucléaire, l'ensemble de bobine comportant une bobine pour transmettre et/ou recevoir des signaux RF et permettant l'accord de fréquence global et l'équilibrage en quadrature de la bobine, l'ensemble de bobine comprenant:
une bobine de type généralement en forme de cage d'oiseau cylindrique (204) renfermant un espace intérieur pour l'introduction d'un échantillon à analyser, la bobine (204) comportant
un premier conducteur annulaire (212) et un deuxième conducteur annulaire (214) disposés autour d'un axe longitudinal central (208) de la bobine et distants axialement l'un de l'autre, et
une pluralité de branches conductrices axiales parallèles (216) s'étendant entre le premier conducteur annulaire (212) et le deuxième conducteur annulaire (214) de manière parallèle à l'axe longitudinal (208) et distants circonférentiellement l'une de l'autre autour de l'axe longitudinal (208), les branches conductrices axiales (216) se terminant à des premières extrémités axiales respectives (218) et des deuxièmes extrémités axiales opposées (220), où les premières extrémités axiales (218) sont positionnées selon un rapport en recouvrement avec le premier conducteur annulaire (212) à une distance radiale du premier conducteur annulaire (212) par rapport à l'axe longitudinal (208) de manière à être couplées capacitivement avec le premier conducteur annulaire, où les deuxièmes extrémités axiales (220) sont positionnées selon un rapport en recouvrement avec le deuxième conducteur annulaire (214) à une distance radiale du deuxième conducteur annulaire (214) par rapport à l'axe longitudinal (208) de manière à être couplées capacitivement au deuxième conducteur annulaire (214); et
une bague d'accord capacitive (222) destinée à ajuster le couplage capacitif entre le premier conducteur annulaire (212) et les branches conductrices axiales (216), la bague d'accord capacitive (222) étant disposée autour de l'axe longitudinal (208) selon un rapport en recouvrement avec les premières extrémités axiales (218) des branches conductrices axiales (216) et avec le premier conducteur annulaire (212), à une distance radiale des premières extrémités axiales (218) des branches conductrices axiales (216) et du premier conducteur annulaire (212) par rapport à l'axe longitudinal (208), la bague d'accord (222) étant déplaçable axialement par rapport à la bobine, la quantité de laquelle la bague d'accord vient en recouvrement axial avec respectivement les premières extrémités axiales (218) des branches conductrices axiales (216) et le premier conducteur annulaire (212) pouvant être ajustée pour un accord global de la bobine;
un premier blindage capacitif (232) et un deuxième blindage capacitif (234), les premier et deuxième blindages capacitifs (232, 234) étant disposés autour de l'axe longitudinal et venant en recouvrement avec respectivement le deuxième conducteur annulaire (214) et les deuxièmes extrémités axiales (220) de deux groupes différents de branches conductrices axiales circonférentiellement adjacentes (216),
dans lequel le premier blindage capacitif (232) est destiné à ajuster le couplage capacitif entre le deuxième conducteur annulaire (214) et les deuxièmes extrémités axiales (220) des branches conductrices axiales (216) d'un premier groupe de branches conductrices axiales circonférentiellement adjacentes, le premier blindage capacitif (232) étant disposé selon un rapport en recouvrement axial avec le deuxième conducteur annulaire (214), d'une part, et avec les deuxièmes extrémités axiales (220) des branches conductrices axiales (216) du premier groupe de branches conductrices axiales, d'autre part, à une distance radiale du deuxième conducteur annulaire (214) et des deuxièmes extrémités axiales (220) des branches conductrices axiales (216) du premier groupe de branches conductrices axiales, et le premier blindage capacitif étant déplaçable axialement par rapport au premier groupe de branches conductrices axiales et au deuxième conducteur annulaire (214), la quantité de laquelle le premier blindage capacitif (232) vient en recouvrement axial avec respectivement le deuxième conducteur annulaire (214) et les deuxièmes extrémités axiales (220) des branches conductrices axiales (216) du premier groupe de branches conductrices axiales pouvant être ajustée,
dans lequel le deuxième blindage capacitif (234) est destiné à ajuster le couplage capacitif entre le deuxième conducteur annulaire (214) et les deuxièmes extrémités axiales (220) des branches conductrices axiales (216) d'un deuxième groupe de branches conductrices axiales circonférentiellement adjacentes, le deuxième blindage capacitif (234) étant décalé circonférentiellement de quatre-vingt-dix degrés du premier blindage capacitif (232) par rapport à l'axe longitudinal (208), le deuxième blindage capacitif (234) étant disposé selon un rapport en recouvrement axial avec le deuxième conducteur annulaire (214), d'une part, et avec les deuxièmes extrémités axiales (220) des branches conductrices axiales (216) du deuxième groupe de branches conductrices axiales, d'autre part, à une distance radiale du deuxième conducteur annulaire (214) et des deuxièmes extrémités axiales (220) des branches conductrices axiales (216) du deuxième groupe de branches conductrices axiales, et le deuxième blindage capacitif étant déplaçable axialement par rapport au deuxième groupe de branches conductrices axiales et au deuxième conducteur annulaire (214), la quantité de laquelle le deuxième blindage capacitif (234) vient en recouvrement axial avec respectivement le deuxième conducteur annulaire (214) et les deuxièmes extrémités axiales (220) des branches conductrices axiales (216) du deuxième groupe de branches conductrices pouvant être ajustée, et dans lequel
les deux blindages capacitifs (232, 234) sont déplaçables l'un par rapport à l'autre dans la direction axiale pour ajuster l'équilibre en quadrature de la bobine, l'ajustement de la position axiale du premier blindage capacitif et l'ajustement de la position axiale du deuxième blindage capacitif fournissant un mécanisme d'accord fin de l'un différent respectif parmi les deux modes orthogonaux d'un mode de fonctionnement en quadrature de la bobine.

2. Ensemble de bobine selon la revendication 1, dans lequel:
en comparaison avec la bague d'accord (222), les blindages capacitifs décalés de quatre-vingt-dix degrés (232, 234) sont de petits arcs, de sorte que l'ajustement axial d'un blindage capacitif (232, 234) n'affectera l'accord de fréquence que d'un seul mode de quadrature.

3. Ensemble de bobine selon la revendication 1, dans lequel la pluralité de branches conductrices axiales (216) sont disposées à une distance radiale supérieure de l'axe longitudinal (208) que le premier conducteur annulaire (212) et le deuxième conducteur annulaire (214), la bague d'accord (222) est disposée à une distance radiale supérieure de l'axe longitudinal que la pluralité de branches conductrices axiales (216), et le premier blindage capacitif (232) et le deuxième blindage capacitif (234) sont disposés à une distance radiale supérieure de l'axe longitudinal que la pluralité de branches conductrices axiales.

4. Ensemble de bobine selon la revendication 1, comportant par ailleurs un mécanisme d'ajustement (1114, 1118, 1124, 1128) comportant un lien couplé au premier blindage capacitif (232) et au deuxième blindage capacitif (234), le lien étant configuré pour déplacer le premier blindage capacitif et le deuxième blindage capacitif simultanément dans des directions axiales opposées en réponse à une entrée d'actionnement du lien.

5. Ensemble de bobine selon la revendication 1, comportant par ailleurs un mécanisme d'ajustement couplé au premier blindage capacitif (232) et au deuxième blindage capacitif (234) et configuré pour déplacer le premier blindage capacitif et le deuxième blindage capacitif individuellement.

6. Ensemble de bobine selon la revendication 1, comportant par ailleurs un premier élément allongé (646) et un deuxième élément allongé (648) disposés de manière parallèle à l'axe longitudinal (208), dans lequel le premier blindage capacitif (232, 632) est couplé de manière mobile au premier élément allongé et le deuxième blindage capacitif (234, 634) est couplé de manière mobile au deuxième élément allongé.

7. Ensemble de bobine selon la revendication 6, dans lequel le premier élément allongé (646) comporte une partie filetée, le premier blindage capacitif (232, 632) comporte une partie filetée venant en prise avec la partie filetée du premier élément allongé, le deuxième élément allongé (648) comporte une partie filetée, le deuxième blindage capacitif (234, 634) comporte une partie filetée venant en prise avec la partie filetée du deuxième élément allongé, et la rotation du premier élément allongé déplace le premier blindage capacitif et la rotation du deuxième élément allongé déplace le deuxième blindage capacitif.

8. Ensemble de bobine selon la revendication 1, comportant par ailleurs des mécanismes d'arrêt destinés à limiter le déplacement axial des blindages capacitifs, les mécanismes d'arrêt comportant un premier mécanisme d'arrêt lié au premier blindage capacitif et un deuxième mécanisme d'arrêt lié au deuxième blindage capacitif.

9. Ensemble de bobine selon la revendication 1, comportant par ailleurs un premier circuit de mise en coïncidence de l'impédance (736) communiquant avec la bobine (604) à un point décalé de 180 degrés du premier blindage capacitif (632) par rapport à l'axe longitudinal (208), et un deuxième circuit de mise en coïncidence de l'impédance (738) communiquant avec la bobine (604) à un point décalé de 180 degrés du deuxième blindage capacitif (634).
